# EUROPEAN PATENT SPECIFICATION

(11) **EP 2 765 605 B1**
(45) Date of publication and mention of the grant of the patent: **08.07.2015**
(21) Application number: 14153997.3
(22) Date of filing: 05.02.2014
(51) Int. Cl.: H01L 27/02, H03K 17/16, H03K 17/082, H01L 27/085, H03K 17/567

(54) **Inverter circuit including short circuit protected composite switch**
Umrichterschaltung mit gegen Kurzschlusströme geschütztem Verbundschalter
Circuit d'inverseur incluant un commutateur composite protégé contre les court-circuits

(30) Priority: 11.02.2013 US 201361763093 P; 03.02.2014 US 201414171687
(43) Date of publication of application: 13.08.2014
(73) Proprietor: International Rectifier Corporation, El Segundo, CA 90245 (US)
(72) Inventor: Briere, Michael A., Scottsdale, AZ Arizona 85266 (US)
(74) Representative: Dr. Weitzel & Partner

(56) References cited:
- EP-A1- 2 006 991
- US-A1- 2011 102 054
- US-B1- 6 483 369

## Description

### BACKGROUND

The present application claims the benefit of and priority to a provisional application entitled "Short Circuit Protected Composite Cascoded Device," Serial No. 61/763,093 filed on February 11, 2013.

### I. DEFINITION

As used herein, "III-Nitride" or "III-N" refers to a compound semiconductor that includes nitrogen and at least one group III element such as aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), aluminum indium gallium arsenide phosphide nitride (AlₓIn_{y}Ga_{(1-x-y)}AsₐP_{b}N_{(1-a-b)}), for example. III-N also refers generally to any polarity including but not limited to Ga-polar, N-polar, semi-polar, or non-polar crystal orientations. A III-N material may also include either the Wurtzitic, Zincblende, or mixed polytypes, and may include single-crystal, monocrystalline, polycrystalline, or amorphous structures. Gallium nitride or GaN, as used herein, refers to a III-N compound semiconductor wherein the group III element or elements include some or a substantial amount of gallium, but may also include other group III elements in addition to gallium. A III-N or a GaN transistor may also refer to a composite high voltage enhancement mode transistor that is formed by connecting the III-N or the GaN transistor in cascode with a lower voltage group IV transistor.

In addition, as used herein, the phrase "group IV" refers to a semiconductor that includes at least one group IV element such as silicon (Si), germanium (Ge), and carbon (C), and may also include compound semiconductors such as silicon germanium (SiGe) and silicon carbide (SiC), for example. Group IV also refers to semiconductor materials which include more than one layer of group IV elements, or doping of group IV elements to produce strained group IV materials, and may also include group IV based composite substrates such as silicon on insulator (SOI), separation by implantation of oxygen (SIMOX) process substrates, and silicon on sapphire (SOS), for example.

It is noted that, as used herein, the terms "low-voltage" or "LV" in reference to a transistor or switch describes a transistor or switch with a voltage range of up to approximately fifty volts (50V). It is further noted that use of the term "midvoltage" or "MV" refers to a voltage range from approximately fifty volts to approximately two hundred volts (approximately 50V to 200V). Moreover, the term "high-voltage" or "HV," as used herein, refers to a voltage range from approximately two hundred volts to approximately twelve hundred volts (approximately 200V to 1200V), or higher.

Furthermore, as used herein, the term "low current" in reference to a switch or transistor describes a switch or transistor that is used to process an average current of less than approximately twenty percent (20 %) of the average load current. In addition, the term "high current" in reference to a switch or transistor describes a switch or transistor that is used to process an average current of greater than 20 % of the average load current. Moreover, the term "saturation current" in reference to a switch or transistor describes the saturation current at maximum overdrive condition of the switch or transistor.

### II. BACKGROUND ART

III-N materials are semiconductor compounds that have relatively wide direct bandgaps and can have strong piezoelectric polarizations, which can enable high breakdown fields, high saturation velocities, and the creation of two-dimensional electron gases (2DEGs). As a result, III-N semiconductors may be desirable for use in many power management applications as field-effect transistors (FETs), including heterostructure FETs (HFETs) such as high electron mobility transistors (HEMTs). Moreover, in power management applications where normally OFF characteristics of power devices are desirable, a depletion mode (normally ON) III-N HEMT can be cascoded with an enhancement mode (normally OFF) low-voltage (LV) group IV transistor, for example a silicon FET, to produce an enhancement mode (normally OFF) composite III-Nitride power switch.

In power inverter applications, for example, a composite III-N power switch including a III-N HEMT cascoded with a group IV FET may be implemented as a high side and/or a low side switch in a switching block configured to drive an inductive load. However, a short circuit condition in such an inductive load may result in the high side switch concurrently experiencing high voltage and high current conditions that may exceed the power handling capacity of the III-N HEMT. One possible approach to protecting the III-N HEMT under these circumstances is to configure the HEMT to have a reduced saturation current. Reducing the saturation current of a III-N HEMT is typically achieved by reducing its effective gate width (Wg), often associated with a reduction in die size. Unfortunately, reducing the Wg and/or die size of the HEMT has the additional and undesirable effects of increasing the on-resistance of the HEMT while reducing its ability to dissipate heat.

### SUMMARY

The present disclosure is directed to an inverter circuit including a short circuit protected composite switch, substantially as shown in and/or described in connection with at least one of the figures, and as set forth more completely in the claims.

### BRIEF DESCRIPTION OF THE DRAWINGS

Figure 1 shows an inverter circuit including a switching block having high side and low side switches implemented using composite III-N switches.
Figure 2 shows a conventional III-N composite switch using a III-N high electron mobility transistor (HEMT) cascoded with a low-voltage (LV) group IV field-effect transistor (FET).
Figure 3 shows a short circuit protected composite III-N switch, according to one implementation.
Figure 4 shows an exemplary inverter circuit including a switching block having high side and low side switches implemented using short circuit protected composite III-N switches, according to one implementation.

### DETAILED DESCRIPTION

The following description contains specific information pertaining to various implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

As noted above, in power management applications where normally OFF characteristics of power devices are desirable, a depletion mode (normally ON) III-N high electron mobility transistor (HEMT) or other type of depletion mode III-N heterostructure field-effect transistor (HFET) can be cascoded with an enhancement mode (normally OFF) low-voltage (LV) group IV transistor, for example a silicon FET, to produce an enhancement mode (normally OFF) composite III-Nitride power switch. Such an arrangement is disclosed in U.S. Patent No. 8,017,978, entitled "Hybrid Semiconductor Device," filed on March 10, 2006, and issued on September 13, 2011.

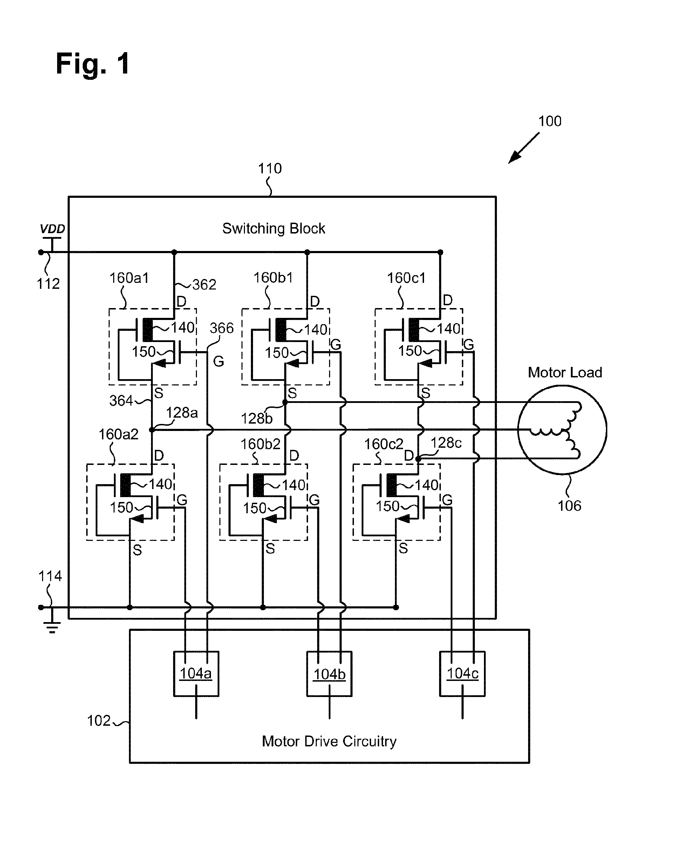

Figure 1 shows an inverter circuit including a switching block having high side and low side switches implemented using composite III-N switches. Inverter circuit 100 includes switching block 110 and motor drive circuitry 102 including switch drivers 104a, 104b, and 104c. Switching block 110 includes composite III-N high side switches 160a1, 160b1, and 160c1 (hereinafter "composite III-N high side switches 160a1-160c1"), and composite III-N low side switches 160a2, 160b2, and 160c2 (hereinafter "composite III-N low side switches 160a2-160c2"). As shown in Figure 1, inverter circuit 100 is configured to drive load 106, which in the present example is shown as a three-phase motor. It is noted that although the present implementation depicts load 106 as a motor, and drive circuitry 102 as motor drive circuitry 102, those representations are merely exemplary. More generally, load 106 may be any inductive load, while drive circuitry 102 may be any suitable drive circuitry 102 for use in inverter circuit 100, which may include half bridge circuits, full bridge circuits, or other power management circuits used to drive an inductive load.

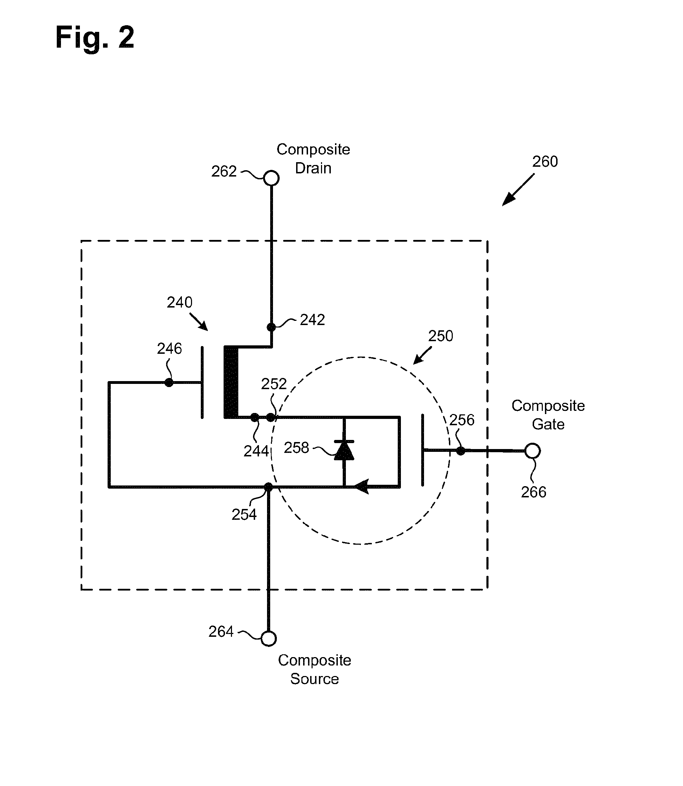

According to the implementation shown in Figure 1, each of composite III-N high side switches 160a1-160c1 and composite III-N low side switches 160a2-160c2 is implemented as a conventional composite switch including high-voltage (HV) III-N FET 140 and group IV FET 150 cascoded with HV III-N FET 140. Composite III-N high side switches 160a1-160c1 and composite III-N low side switches 160a2-160c2 correspond in general to conventional composite III-N switch 260, shown in Figure 2. In other words, HV III-N FETs 140 and group IV FETs 150, in Figure 1, correspond respectively to HV group III-N FET 240 and group IV FET 250, in Figure 2, and may share any of the characteristics attributed to those corresponding features, below.

Switching block 110 is shown to include three half bridge circuits coupled between high voltage rail 112 and low voltage rail 114 and configured to provide three outputs from switch nodes 128a, 128b, and 128c for driving respective three phases of load 106. That is to say, a first half bridge circuit formed by composite III-N high side switch 160a1 and composite III-N low side switch 160a2 provides a first output through switch node 128a for driving a first phase of load 106. Moreover, a second half bridge circuit formed by composite III-N high side switch 160b1 and composite III-N low side switch 160b2 provides a second output through switch node 128b for driving a second phase of load 106. In addition, a third half bridge circuit formed by composite III-N high side switch 160c1 and composite III-N low side switch 160c2 provides a third output through switch node 128c for driving a third phase of load 106. As further shown in Figure 1, switch driver 104a is coupled to the composite gates of composite III-N high side switch 160a1 and composite III-N low side switch 160a2, while switch driver 104b is coupled to the composite gates of composite III-N high side switch 160b1 and composite III-N low side switch 160b2, and switch driver 104c is coupled to the composite gates of composite III-N high side switch 160c1 and composite III-N low side switch 160c2.

Although not shown explicitly in Figure 1, it is noted that motor drive circuitry 102 is configured to receive a feedback signal from load 106 and/or switching block 110 enabling detection of a short circuit condition in load 106. For example, inverter circuit 100 may utilize motor drive circuitry 102 to monitor the load current for all three motor phases of load 106. In the event that a predetermined current limit is exceeded, motor drive circuitry 102 detects the presence of a short circuit condition and causes switch driver 104a, and/or switch driver 104b, and/or switch driver 104c to turn OFF the affected switches.

In the event that load 106 does experience a short circuit condition, as the result, for example, of seized rotor and/or stator coils, the inductance of load 106 may drop to substantially zero, resulting in a very high current running through one or more of the composite III-N switches in switching block 110. For instance, under such conditions, each of composite III-N high side switches 160a1-160c1 would be exposed to the full voltage provided at high voltage rail 112, which may be approximately three hundred and fifty volts (350 V), or greater. Moreover, due to the short circuit condition, a large current, such as an approximately thirty-five amp (35 A) current, for example, would concurrently pass through those composite III-N switches and III-N HEMTs. As a result, composite III-N high side switches 160a1-160c1 would need to be able to dissipate approximately twelve kilowatts (12 kW) of power for the duration of the short circuit condition in order to survive.

To protect conventional composite III-N high side switches 160a1-160c1 from such a short circuit condition, inverter circuit 100 may utilize motor drive circuitry 102 to monitor the load current for all three motor phases of load 106. In the event that a predetermined current limit is exceeded, motor drive circuitry 102 detects the presence of a short circuit condition and causes switch driver 104a, and/or switch driver 104b, and/or switch driver 104c to turn OFF the affected switches. The delay time required for motor drive circuitry 102 to detect an excessive load current and cause the affected switch to be turned OFF can typically be as long as approximately two to approximately ten microseconds (approximately 2-10 µs). Consequently, in the event of a short circuit condition in load 106 under the example operating conditions described above, composite III-N high side switches 160a1-160c1 would need to be able to handle approximately 12 kW for a period of 2-10 µs, which exceeds the power capacity of most HEMTs.

One possible additional measure that may be taken to protect the composite III-N switches implemented in inverter switching block 110 of inverter circuit 100 is to configure the HEMTs so as to limit their saturation current. Reducing the saturation current of HEMTs is typically achieved by reducing their effective gate width (Wg), which is usually associated with a reduction in die size. Unfortunately, reducing Wg and/or the die size of the HEMTs has the additional and undesirable affects of increasing their on-resistance while reducing their ability to dissipate heat. As a result, the reductions in HEMT Wg and/or die size required to adequately limit saturation current may unacceptably diminish the power handling performance of the resulting HEMTs, rendering them unsuitable for use in switching block 110 of inverter circuit 100.

Referring to Figure 2, Figure 2 shows conventional composite switch 260 including HV III-N HEMT 240 and LV group IV FET 250. As further shown in Figure 2, LV group IV FET 250 includes diode 258, which may be a body diode of LV group IV FET 250, for example. Also shown in Figure 2 are composite source 264, composite drain 262, and composite gate 266 of composite switch 260.

HV III-N FET 240 may be a III-N based HEMT configured to incorporate a two-dimensional electron gas (2DEG), and may take the form of a depletion mode (normally ON) III-N based HEMT. In some implementations, HV III-N FET 240 may be an insulated gate device, such as a metal-insulator-semiconductor HFET (MISHFET), metal-oxide-semiconductor HFET (MOSHFET), a Schottky gated FET, or may incorporate a P-N junction its gate structure.

LV Group IV FET 250 may be implemented as a silicon FET having a breakdown voltage of approximately 25 V to approximately 40 V, for example. According to one implementation, LV group IV FET 250 may be a silicon MISFET or MOSFET, for example, including body diode 258. It is noted that in some implementations, LV group IV FET 250 may take the form of a vertical channel trench type FET, while in other implementations, LV group IV FET 250 may be a lateral channel FET.

The cascoded combination of HV III-N FET 240 and LV group IV FET 250 produces composite switch 260, which according to the implementation shown in Figure 2 results in a composite three terminal device functioning in effect as a FET having composite source 264 and composite gate 266 provided by LV group IV FET 250, and composite drain 262 provided by HV III-N FET 240. That is to say, drain 252 of LV group IV FET 250 is coupled to source 244 of HV III-N FET 240, source 254 of LV group IV FET 250 provides composite source 264 for composite switch 260, and gate 256 of LV group IV FET 250 provides composite gate 266 for composite switch 260. Moreover, drain 242 of HV III-N FET 240 provides composite drain 262 for composite switch 260, while gate 246 of HV III-N FET 240 is coupled to source 254 of LV group IV FET 250.

Several examples of composite III-N switches are described in U.S. Patent No. 8,017,978, entitled "Hybrid Semiconductor Device," filed on March 10, 2006, and issued on September 13, 2011, which is referenced above, as well as in U.S. Patent No. 8,368,120, entitled "Hybrid Semiconductor Device Having a GaN Transistor and a Silicon MOSFET," filed on September 2, 2011, and issued on February 5, 2013; U.S. Patent No. 8,084,783, entitled "GaN-Based Device Cascoded with an Integrated FET/Schottky Diode Device," filed on November 9, 2009, and issued on December 27, 2011; U.S. Patent Application No. 13/053,556, entitled "III-Nitride Transistor Stacked with FET in a Package," and filed on March 22, 2011; U.S. Patent Application No. 13/415,779, entitled "Composite Semiconductor Device with Turn-On Prevention Control," and filed on March 8, 2012; U.S. Patent Application No. 13/416,252, entitled "High Voltage Composite Semiconductor Device with Protection for a Low Voltage Device," and filed on March 9, 2012; U.S. Patent Application No. 13/419,820, entitled "III-Nitride Transistor with Passive Oscillation Prevention," and filed on March 14, 2012; U.S. Patent Application No. 13/417,143, entitled "Composite Semiconductor Device with Active Oscillation Prevention," and filed on March 9, 2012; U.S. Patent Application No. 13/433,864. entitled "Stacked Composite Device Including a Group III-V Transistor and a Group IV Lateral Transistor," and filed on March 29, 2012; U.S. Patent Application No. 13/434,412, entitled "Stacked Composite Device Including a Group III-V Transistor and a Group IV Vertical Transistor," and filed on March 29, 2012; U.S. Patent Application No. 13/780,436, entitled "Group III-V and Group IV Composite Switch," and filed on February 28, 2013; U.S. Patent Application No. 14/073,783, entitled "Cascode Circuit Integration of Group III-N and Group IV Devices," and filed on November 6, 2013; and provisional patent Application No. 61/763,115, entitled "Half Bridge Circuit with Integrated Cascoded Device," filed on February 11, 2013.

The operation of composite switch 260 implemented as an enhancement mode (normally OFF) switch formed from LV group IV FET 250 cascoded with depletion mode (normally ON) HV III-N FET 240 will now be described by reference to specific, but merely exemplary, parameters. For example, as voltage is increased at composite drain 262 of composite switch 260 while HV III-N FET 240 is ON, a few volts (e.g., approximately 10 V) will develop across reverse biased diode 258 of LV group IV FET 250. This voltage is applied to gate 246, with respect to source 244 of HV III-N FET 240 in the inverse polarity (e.g., as an approximately -10 V gate-to-source voltage). In response, HV III-N FET 240 will turn OFF (e.g., assuming a pinch-off voltage magnitude of less than 10 V) and any additional increase in the drain voltage at composite drain 262 will be sustained across drain 242 and source 244 of HV III-N FET 240.

Thus, LV group IV FET 250 including diode 258 will typically not be required to sustain an average voltage beyond the first few volts (e.g., approximately 10 V) applied to composite drain 262. When composite switch 260 is in the ON-state, a small voltage is usually present across LV group IV FET 250. That voltage is developed across source 254 and drain 252 of LV group IV FET 250 and is essentially the product of the on-resistance and the current passing from the source-drain terminal of LV group IV FET 250, and is typically less than approximately 1.0 volt. This condition leaves the gate-source voltage of HV III-N FET 240 at less than approximately 1.0 V, thereby driving HV III-N FET 240 into, or maintaining HV III-N FET 240 in, the ON-state. However, if the current through the LV group IV FET 250 approaches substantially its saturation current limit, a large voltage can develop across LV group IV FET 250. This saturation driven voltage can be as high as the forward breakdown voltage of LV group IV FET 250. This breakdown voltage may be similar in magnitude to the reverse breakdown voltage, or the device rating of LV group IV FET 250, which may be between approximately 25V to approximately 40 V, for example, as noted above. That saturation driven voltage will then be impressed, in the reverse polarity, between gate 246 and source 244 of HV III-N FET 240.

In implementations in which the magnitude of the pinch-off voltage is, as in the present example, less than 10 V, HV III-N FET 240 will be turned OFF. When HV III-N FET 240 turns OFF, the current through LV group IV FET 250 will decrease towards zero amps. As a result, the voltage developed across LV group IV FET 250 will fall toward zero volts. When the voltage developed across the LV group IV FET 250 falls below the pinch-off voltage of HV III-N FET 240, HV III-N FET 240 will turn back ON. If the current through LV group IV FET 250 again approaches its saturation limit, the cycle will repeat itself. In this way the voltage across the cascoded switch will be found to oscillate strongly. This is very undesirable and should be avoided.

The present application discloses a short circuit protected composite switch configured to address and overcome the problems described above. The short circuit protected composite switch disclosed in the present application advantageously exhibits a reduced saturation current while concurrently providing the low on-resistance and large thermal dissipation capability characteristic of III-N switches. In addition, the short circuit protected composite switch disclosed in the present application is advantageously configured to avoid the strong oscillations seen in the conventional art.

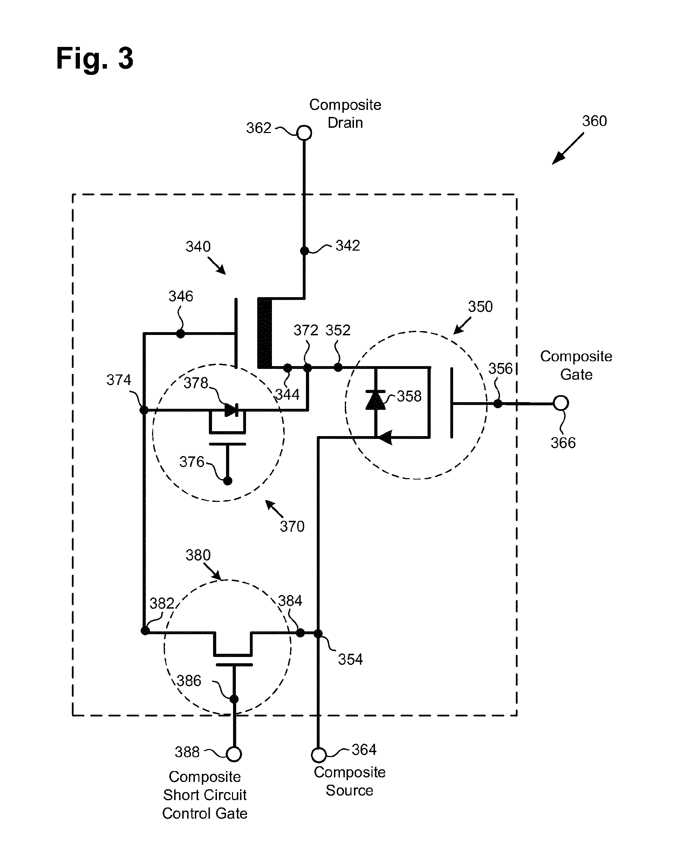

Referring to Figure 3, Figure 3 shows short circuit protected composite switch 360, according to one implementation. Short circuit protected composite switch 360 includes III-N FET 340 having drain 342, source 344, and gate 346. Short circuit protected composite switch 360 also includes high current group IV FET 350 having drain 352, source 354, and gate 356, and including diode 358, which may be a body diode of high current group IV FET 350. In addition, short circuit protected composite switch 360 includes another group IV FET 370 having drain 372, source 374, gate 376, and including diode 378, which may also be a body diode, as well as another transistor 380, which may also be a FET and include drain 382, source 384, and gate 386.

As shown by Figure 3, high current group IV FET 350 is coupled in series with III-N HEMT 340, while transistor 380, which may be a low current transistor, is coupled between gate 346 of III-N FET 340 and source 354 of high current group IV FET 350. Moreover, group IV FET 370, which may also be a low current transistor, is coupled between gate 346 and source 344 of said III-N FET 340. In one implementation, gate 376 of low current group IV FET 370 can be tied to the same potential as gate 356 of high current group IV FET 350. Thus, short circuit protected composite switch 360 can be implemented as a four terminal device having composite drain 362, composite gate 366, composite source 364, and composite short circuit control gate 388.

In some implementations, III-N FET 340 may be an HV III-N FET. Moreover, in some implementations III-N FET 340 may be a depletion mode (normally ON) III-N based HEMT, configured to incorporate a 2DEG. In some implementations, III-N FET 340 may be an insulated gate device, such as a MISHFET, a MOSHFET, a Schottky gated transistor, or may incorporate a P-N junction in its gate structure.

High current group IV FET 350 may be implemented as a high current silicon FET having a breakdown voltage of approximately 25 V to approximately 40 V, for example. According to one implementation, high current group IV FET 350 may be a silicon MISFET or MOSFET, for example, including body diode 358. It is noted that in some implementations, high current group IV FET 350 may take the form of a vertical channel trench type FET, while in other implementations, high current group IV FET 350 may be a lateral channel FET. It is noted that high current group IV FET 350 is configured to have a well controlled saturating current behavior such that the maximum current flowing between source 354 and drain 352 is less than the maximum rated current handling capability of III-N FET 340 under short circuit conditions for a given short circuit time (tsc) specification. In one implementation, for example, a saturation current of high current group IV FET 350 is less than a maximum current that III-N FET 340 can sustain in a short circuit condition for at least 2.0 µs.

When transistor 380 is in the ON-state, short circuit protected composite switch 360 behaves analogously to composite switch 260, the operation of which is discussed in some detail above. Short circuit protected composite switch 360 operates as a composite four terminal device functioning in effect as a FET having composite source 364 and composite gate 366 provided by the parallel combination high current group IV FET 350 and transistor 380, with gates 356 and 376 of respective high current group IV FET 350 and low current group IV FET 370 tied to the same potential, with composite short circuit control gate 388 provided by transistor 380, and composite drain 362 provided by III-N FET 340. That is to say, drain 352 of high current group IV FET 350 is coupled to source 344 of III-N FET 340, source 354 of high current group IV FET 350 together with source 374 of low current group IV FET 370 through transistor 380 when in the ON-state, provide composite source 364 for short circuit protected composite switch 360. In addition, gate 356 of high current group IV FET 350 provides composite gate 366 for short circuit protected composite switch 360. Moreover, drain 342 of III-N FET 340 provides composite drain 362 for short circuit protected composite switch 360, while gate 346 of III-N FET 340 is coupled to source 374 of low current group IV FET 370, and to source 354 of high current group IV FET 350 through the low resistance path provided by transistor 380 when it is in the ON-state.

However, in the case when the current through high current group IV FET 350 approaches its saturation current, while it is in the ON-state, low current transistor 380 can be switched to the OFF-state. While in the OFF-state, with both the group IV FETs 350 and 370 in the ON-state (i.e., gate voltage greater than threshold voltage), the III-N FET 340 is maintained in the ON-state. A large voltage can develop across source 354 and drain 352 of high current group IV FET 350. However, as source 374 of group IV FET 370 now is essentially disconnected from composite source 364 and high current group IV FET 350 provides a low resistance current path to composite source 364, substantially no portion of the current flowing between source 344 and drain 342 of III-N FET 340 is forced to flow through group IV FET 370. As a result, the voltage across source 374 and drain 372 of group IV FET 370, and consequently the associated voltage across gate 346 and source 344 III-N FET 340, remain less than approximately 1.0 V. In this way III-N FET 340 can remain in the ON-state and the previously described oscillation effect seen in conventional implementations can be avoided. When the current flowing in high current group IV FET 350 reduces substantially below its saturation limit, transistor 380 is switched back into the ON-state and short circuit protected composite switch 360 operates as described above.

Because the useful operation of short circuit protected composite switch 360 requires that transistor 380 be in the ON-state, except during the unusual short circuit condition, it may be advantageous or desirable to implement transistor 380 as a normally ON switch. Such a normally ON transistor 380 may be a group IV device such as a junction gate FET (JFET), accumulation channel FET (accuFET), or a depletion mode MISFET, or it may be a group III-V device such as a gallium arsenide (GaAs), indium phosphide (InP), or III-N HEMT or other type of III-N FET, which maybe an insulated gate, Schottky gated, or P-N junction gated device.

Under substantially all desirable operating conditions, transistor 380 will be required to process drive current to gate 346 of III-N FET 340, which is typically in the form of pulses of approximately 1.0 A to approximately 10 A for approximately 1.0 ns to approximately 100 ns. In addition, transistor 380 will develop relatively small voltages across its source 384 and drain 382, typically less than 1.0 V. Consequently, transistor 380 can be designed to have a significantly lower breakdown voltage than III-N FET 340. Thus, transistor 380 can be sized with a relatively small Wg when compared to III-N FET 340.

Transistor 380 may be co-packaged, directly mounted, or monolithically integrated with either III-N FET 340 or high current group IV FET 350. In one implementation, for example, transistor 380 may be monolithically integrated with both of III-N FET 340 and high current group IV FET 350. Moreover, low current group IV FET 370 can be co-packaged or monolithically integrated with III-N FET 340 and/or high current group IV FET 350. Furthermore, in some implementations, III-N FET 340, high current group IV FET 350, group IV FET 370, transistor 380 may all be monolithically integrated using a common silicon substrate.

Control of transistor 380 can be accomplished through the logical combination of two control conditions. The first control condition may be true ("1") when high current group IV FET 350 is in the ON-state, that is that the voltage applied to composite gate 366 exceeds the specified threshold voltage of high current group IV FET 350. The second control condition may be true ("1") when a short circuit condition exists, as indicated by the current in the load, determined as previously discussed, or by the current through high current group IV FET 350, as detected, for example, through monitoring of the source-to-drain voltage of high current group IV FET 350. When such a short circuit current exceeds the specified overcurrent limit condition of short circuit protected composite switch 360, in other words, a short circuit condition exists.

When both conditions are true, the voltage applied to gate 386 of transistor 380 through composite short circuit control gate 388 is adjusted to turn transistor 380 OFF. If transistor 380 is, for example, a III-N switch, the applied gate voltage to turn transistor 380 OFF would have a negative polarity with respect source 384, which is tied to the composite source 364, with a magnitude in excess of the magnitude of the pinch-off voltage for transistor 380. Implementation of this control logic for the gate drive of transistor 380 can be performed discretely with external comparators and an AND (or NAND), gate or it may be incorporated in the circuitry of the gate driver used to drive composite gate 366, in which exists information regarding the status of composite gate 366 and the current in the load. The response time of the control circuitry to the existence of a short circuit condition must be considerably more rapid than the previously discussed 2-10 µs control response. In one implementation, the response time for control of the transistor 380 is less than approximately 100 ns, preferably less than approximately 10 ns. In addition, in some implementations, the turn-OFF time of transistor 380 is less than approximately 10 ns. In other words, in some implementations, transistor 380 is configured to turn OFF in less than approximately 100 ns after a short circuit condition is detected. In this way, potential oscillations of the voltage across short circuit protected composite switch 360 can be adequately minimized.

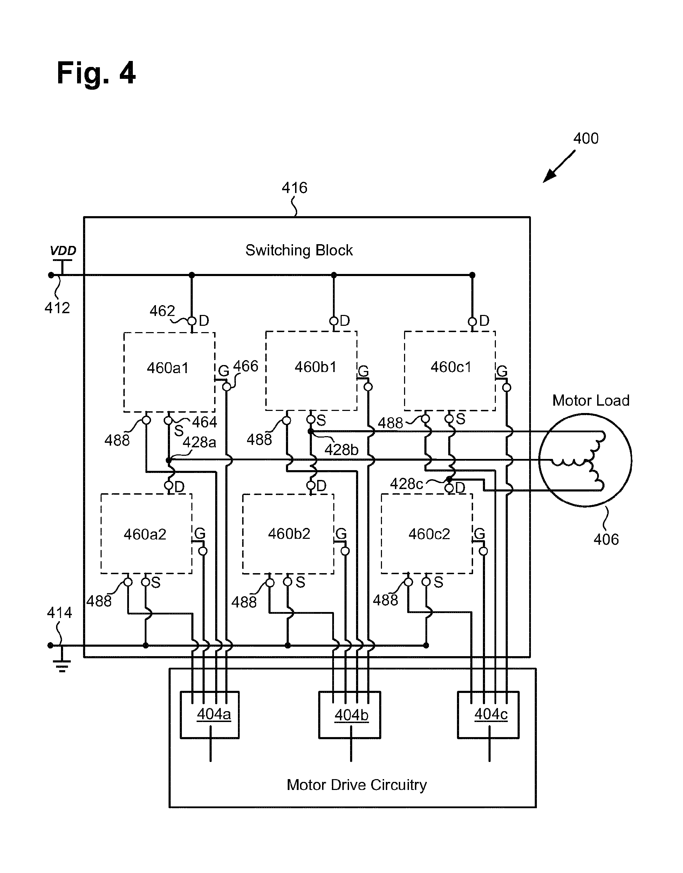

Referring now to Figure 4, Figure 4 shows an exemplary inverter circuit including a switching block having high side and low side switches implemented using short circuit protected composite switches, according to one implementation. Inverter circuit 400 includes switching block 416 and motor drive circuitry 402 including switch drivers 404a, 404b, and 404c. Also shown in Figure 4 is load 406 driven by inverter circuit 400, which in the present example is shown as a three-phase motor. It is noted that although the present implementation depicts load 406 as a motor, and drive circuitry 402 as motor drive circuitry 402, those representations are merely exemplary. More generally, load 406 may be any inductive load, while drive circuitry 402 may be any suitable inverter drive circuitry 402 for use in inverter circuit 400. More generally, a circuit corresponding to inverter circuit 400 may include other topologies than the inverter circuit 400 shown in Figure 4. Examples of such topologies include half bridge circuits, full bridge circuits, or other power management circuits used to drive an inductive load,

Switching block 416 includes high side short circuit protected composite switches 460a1, 460b1, and 460c1 (hereinafter "high side short circuit protected composite switches 460a1-460c1"), and low side short circuit protected composite switches 460a2, 460b2, and 460c2 (hereinafter "low side short circuit protected composite switches 460a2-460c2"). It is noted that each of high side short circuit protected composite switches 460a1-460c1 and low side short circuit protected composite switches 460a2-460c2 correspond in general to short circuit protected composite switch 360, in Figure 3, and may share any of the characteristics attributed to that corresponding element above.

As may be seen by reference to Figure 3 in combination with Figure 4, according to the present exemplary implementation, each of high side short circuit protected composite switches 460a1-460c1 and low side short circuit protected composite switches 460a2-460c2 is implemented as a short circuit protected composite switch including III-N FET 340 and high current group IV FET 350, in combination with group IV FET 370 and transistor 380, as described above. As shown in Figure 4, each of high side short circuit protected composite switches 460a1-460c1 and low side short circuit protected composite switches 460a2-460c2 has composite drain 462, composite source 464, composite gate 466, and composite short circuit control gate 488.

Switching block 416 is shown to include three half bridge circuits coupled between high voltage rail 412 and low voltage rail 414 and configured to provide three outputs from switch nodes 428a, 428b, and 428c for driving respective three phases of load 406. That is to say, a first half bridge circuit formed by high side short circuit protected composite switch 460a1 and low side short circuit protected composite switch 460a2 provides a first output through switch node 428a for driving a first phase of load 406. Moreover, a second half bridge circuit formed by high side short circuit protected composite switch 460b1 and low side short circuit protected composite switch 460b2 provides a second output through switch node 428b for driving a second phase of load 406. In addition, a third half bridge circuit formed by high side short circuit protected composite switch 460c1 and low side short circuit protected composite switch 460c2 provides a third output through switch node 428c for driving a third phase of load 406. As further shown in Figure 4, switch driver 404a is coupled to the composite gates of high side short circuit protected composite switch 460a1 and low side short circuit protected composite switch 460a2, while switch driver 404b is coupled to the composite gates of high side short circuit protected composite switch 460b1 and low side short circuit protected composite switch 460b2, and switch driver 404c is coupled to the composite gates of high side short circuit protected composite switch 460c1 and low side short circuit protected composite switch 460c2.

Although not shown explicitly in Figure 4, it is noted that motor drive circuitry 402 is configured to receive a feedback signal from load 406 and/or switching block 416 enabling detection of a short circuit condition in load 406. For example, inverter circuit 400 may utilize motor drive circuitry 402 to monitor the load current for all three motor phases of load 406. In the event that a predetermined current limit is exceeded, meaning an overcurrent limit condition exists, motor drive circuitry 402 detects the presence of a short circuit condition and causes switch driver 404a, and/or switch driver 404b, and/or switch driver 404c to turn OFF the affected switches.

In the event that load 406 does experience an overcurrent condition or short circuit condition, as the result, for example, of seized rotor and/or stator coils of the motor, the inductance of load 406 may drop to substantially zero, resulting in a short circuit current running through one or more of the short circuit protected composite switches in switching block 416. As discussed above by reference to Figure 1, during a short circuit condition in load 406, each of high side short circuit protected composite switches 460a1-460c1 would be exposed to the full voltage provided at high voltage rail 412, which may be approximately 350 V, while concurrently passing the short circuit current.

However, in contrast to the potentially catastrophic results discussed above when conventional cascoded HEMTs are used to implement the high side switches, high side short circuit protected composite switches 460a1-460c1 are configured to limit the current through III-N FETs 340. For example, as discussed above, high current group IV FETs 350 may be sized so as to have a predetermined saturation current, substantially limiting the current through III-N FETs 340 to a predetermined current value within the current handling capability of III-N FET 340, which may be significantly less then the saturation current III-N FET 340.

In implementations where the high side and low side switches are configured as short circuit protected composite cascoded switches, as depicted in Figures 3 and 4. The short circuit protected composite switch configuration described in Figure 3 will also prevent the strong oscillations which may otherwise occur in a short circuit condition. This can be accomplished by turning transistor 380 of the short circuit protected composite switch 360 into the OFF-state, as previously described in reference to Figure 3. However, it is noted that the current limit used to control gate 386 of transistor 380 needs to be less than the saturation current of high current group IV FET 350, such that the magnitude of the voltage developed across source 354 and drain 352 of high current group IV FET 350 in the ON-state is less than the magnitude of the pinch-off voltage of III-N FET 340, at the current limit, in order to substantially prevent oscillation of the short circuit protected composite switch.

In some implementations, high current group IV FETs 350 may be sized so as to limit their respective saturation currents to correspond to a steady state load current of load 406. As a specific example, high current group IV FETs 350 may be sized so as to limit their respective saturation currents to less than or approximately equal to three times a steady state load current of load 406. If that steady state load current were 2 A, for instance, high current group IV FETs 350 can be sized to limit their saturation current to 6 A, or less. As a result, high side short circuit protected composite switches 460a1-460c1 would need to be able to handle a short circuit current of up to 6 A for the time required to turn those switches OFF. Thus, in contrast to high side switches 160a1-160c1, in Figure 1, which would need to be able to dissipate approximately 12 kW of power for 2-10 µs in order to survive a short circuit condition, high side short circuit protected composite switches 460a1-460c1 can survive under comparable control conditions if they can dissipate approximately 2 kW for the same time interval. In other words, high side short circuit protected composite switches 460a1-460c1 enjoy substantial short circuit protection.

It is noted that although Figure 4 depicts all of high side short circuit protected composite switches 460a1-460c1 and low side short circuit protected composite switches 460a2-460c2 as being short circuit protected composite switches, in other implementations less than all of the high side switches and low side switches may be implemented in that manner. In some implementations, at least one of the high side and low side switches in each half bridge circuit of switching block 416 will take the form of short circuit protected composite switches. For example, in one implementation, the high side switches of switching block 416 may be implemented as high side short circuit protected composite switches 460a1-460c1, while the low side switches may not be.

Thus, the present application discloses a short circuit protected composite III-N switch. By cascoding a high current group IV FET having a predetermined saturation current with a III-N FET, various implementations of the present solution provide short circuit protection for the III-N FET. In addition, because a maximum short circuit current through the III-N FET is reduced without reducing the size of the III-N FET, the desirable low on-resistance and thermal dissipation properties of the III-N FET are advantageously preserved. As a result, the present solution enables implementation of an inverter circuit including high performance and highly durable composite switches capable of surviving short circuit load conditions.

## Claims

1. A short circuit protected composite switch comprising:
a III-N field-effect transistor (FET) including a drain, a source, and a gate;
a high current group IV FET coupled in series with said III-N FET;
said high current group IV FET limiting a current through said III-N FET;
another group IV FET coupled between said gate of said III-N FET and said source of said III-N FET;
another transistor coupled between said gate of said III-N FET and a source of said high current group IV FET.

2. The short circuit protected composite switch of claim 1, wherein said III-N FET is a normally-ON III-N high electron mobility transistor (HEMT).

3. The short circuit protected composite switch of claim 1, wherein said another transistor is a normally-ON transistor.

4. The short circuit protected composite switch of claim 1, wherein said III-N FET and said another transistor are monolithically integrated.

5. The short circuit protected composite switch of claim 1, wherein said high current group IV FET and said another group IV FET are monolithically integrated.

6. The short circuit protected composite switch of claim 1, wherein said III-N FET, said high current group IV FET, said another group IV FET, and said another transistor are monolithically integrated on a common substrate.

7. The short circuit protected composite switch of claim 1, wherein a gate of said high current group IV FET is tied to a same potential as a gate of said another group IV FET.

8. The short circuit protected composite switch of claim 1, further comprising four external connections, wherein said four external connections include a composite drain, a composite source, a composite gate and a composite short circuit control gate of said short circuit protected composite switch.

9. The short circuit protected composite switch of claim 1, wherein said another transistor is in an OFF-state when an over-current limit condition exists and said short circuit protected composite switch is in an ON-state.

10. A circuit comprising:
a switching block;
at least one short circuit protected composite switch included in said switching block of said circuit, said at least one short circuit protected composite switch comprising:
a III-N field-effect transistor (FET) including a drain, a source, and a gate;
a high current group IV FET coupled in series with said III-N FET;
said high current group IV FET limiting a current through said III-N FET;
another group IV FET coupled between said gate of said III-N FET and said source of said III-N FET;
another transistor coupled between said gate of said III-N FET and a source of said high current group IV FET.

11. The circuit of claim 10, wherein said circuit is a three-phase circuit.

12. The circuit of claim 10, wherein said circuit is a full bridge circuit.

13. The circuit of claim 10, wherein said circuit is a half bridge circuit.

14. The circuit of claim 10, wherein said circuit is a motor drive inverter.

15. The circuit of claim 10, wherein said circuit is configured to drive an inductive load.

## Patentansprüche

1. Kurzschlussgeschützter Verbundschalter, umfassend:
einen III-N-Feldeffekttransistor (FET) mit einem Drain, einer Source und einem Gate;
einen Hochstrom-Gruppe IV-FET, der mit dem III-N-FET in Reihe geschaltet ist;
wobei der Hochstrom-Gruppe IV-FET einen Strom durch den III-N-FET begrenzt;
einen weiteren Gruppe IV-FET, der zwischen das Gate des III-N-FET und die Source des III-N-FET zwischengeschaltet ist;
einen weiteren Transistor, der zwischen das Gate des III-N-FET und eine Source des Hochstrom-Gruppe IV-FET zwischengeschaltet ist.

2. Kurzschlussgeschützter Verbundschalter nach Anspruch 1, wobei der III-N-FET ein normalerweise eingeschalteter III-N-Transistor mit hoher Elektronenbeweglichkeit (HEMT) ist.

3. Kurzschlussgeschützter Verbundschalter nach Anspruch 1, wobei der weitere Transistor ein normalerweise eingeschalteter Transistor ist.

4. Kurzschlussgeschützter Verbundschalter nach Anspruch 1, wobei der III-N-FET und der weitere Transistor monolithisch integriert sind.

5. Kurzschlussgeschützter Verbundschalter nach Anspruch 1, wobei der Hochstrom-Gruppe IV-FET und der weitere Gruppe IV-FET monolithisch integriert sind.

6. Kurzschlussgeschützter Verbundschalter nach Anspruch 1, wobei der III-N-FET, der Hochstrom-Gruppe IV-FET, der weitere Gruppe IV-FET und der weitere Transistor auf einem gemeinsamen Substrat monolithisch integriert sind.

7. Kurzschlussgeschützter Verbundschalter nach Anspruch 1, wobei ein Gate des Hochstrom-Gruppe IV-FET mit einem gleichen Potential verknüpft ist wie ein Gate eines weiteren Gruppe IV-FET.

8. Kurzschlussgeschützter Verbundschalter nach Anspruch 1, ferner umfassend vier externe Anschlüsse wobei die vier externen Anschlüsse einen Komposit-Drain, eine Komposit-Quelle, ein Komposit-Gate und ein Komposit-Kurzschluss-Steuergate des kurzschlussgeschützten Verbundschalters aufweisen.

9. Kurzschlussgeschützter Verbundschalter nach Anspruch 1, wobei sich der weitere Transistor in einem ausgeschalteten Zustand befindet, wenn eine Überstrom-Grenzbedingung vorliegt und sich der kurzschlussgeschützte Verbundschalter in einem eingeschalteten Zustand befindet.

10. Schaltung, umfassend:
einen Schaltblock;
mindestens einen kurzschlussgeschützten Verbundschalter, der in dem Schaltblock der Schaltung enthalten ist, wobei der mindestens eine kurzschlussgeschützte Verbundschalter folgendes umfasst:
einen III-N-Feldeffekttransistor (FET) mit einem Drain, einer Source und einem Gate;
einen Hochstrom-Gruppe IV-FET, der mit dem III-N-FET in Reihe geschaltet ist;
wobei der Hochstrom-Gruppe IV-FET einen Strom durch den III-N-FET begrenzt;
einen weiteren Gruppe IV-FET, der zwischen das Gate des III-N-FET und die Source des III-N-FET zwischengeschaltet ist;
einen weiteren Transistor, der zwischen das Gate des III-N-FET und eine Source des Hochstrom-Gruppe IV-FET zwischengeschaltet ist.

11. Schaltung nach Anspruch 10, wobei die Schaltung eine dreiphasige Schaltung ist.

12. Schaltung nach Anspruch 10, wobei die Schaltung eine Vollbrückenschaltung ist.

13. Schaltung nach Anspruch 10, wobei die Schaltung eine Halbbrückenschaltung ist.

14. Schaltung nach Anspruch 10, wobei die Schaltung ein Motorantriebsinverter ist.

15. Schaltung nach Anspruch 10, wobei die Schaltung dazu eingerichtet ist, eine induktive Last anzusteuern.

## Revendications

1. Un interrupteur composite protégé contre les courts-circuits comprenant :
Un transistor à effet de champ III-N (FET) comprenant un drain, une source et une grille ;
Un FET du groupe IV de haute intensité raccordé en série à ce FET III-N ;
Ledit FET du groupe IV de haute intensité limitant un courant au travers dudit FET III-N ;
Un autre FET du groupe IV raccordé entre ladite grille dudit FET III-N et ladite source dudit FET III-N ;
Un autre transistor raccordé entre ladite grille dudit FET III-N et une source dudit FET de groupe IV de haute intensité.

2. L'interrupteur composite protégé contre les courts-circuits de la revendication 1, où ledit FET III-N est un transistor à grande mobilité d'électrons III-N normalement ON (HEMT).

3. L'interrupteur composite protégé contre les courts-circuits de la revendication 1, où cet autre transistor est un transistor normalement ON.

4. L'interrupteur composite protégé contre les courts-circuits de la revendication 1, où ledit FET III-N et cet autre transistor sont intégrés de façon monolithique.

5. L'interrupteur composite protégé contre les courts-circuits de la revendication 1, où ledit FET du groupe IV de haute intensité et cet autre FET du groupe IV sont intégrés de façon monolithique.

6. L'interrupteur composite protégé contre les courts-circuits de la revendication 1, où ledit FET III-N, ledit FET du groupe IV de haute intensité, cet autre FET du groupe IV, et cet autre transistor sont intégrés de façon monolithique sur un substrat commun.

7. L'interrupteur composite protégé contre les courts-circuits de la revendication 1, où une grille dudit FET du groupe IV de haute intensité est lié à un même potentiel comme une grille d'un autre FET du groupe IV.

8. L'interrupteur composite protégé contre les courts-circuits de la revendication 1, comprenant de plus quatre connexions extérieures, où ces quatre connexions extérieures incluent un drain composite, une source composite, une grille composite et une grille de contrôle de court-circuit composite dudit interrupteur composite protégé des courts-circuits.

9. L'interrupteur composite protégé contre les courts-circuits de la revendication 1, où l'autre transistor est dans un état OFF lorsqu'une condition de limite de surtension existe et ledit interrupteur composite protégé contre les courts-circuits est dans un état ON.

10. Un circuit comprenant :
Un bloc de commutation ;
Au moins un interrupteur composite protégé contre les courts-circuits inclus dans ledit bloc de commutation dudit circuit, au moins un interrupteur composite protégé contre les courts-circuits comprenant :
Un transistor à effet de champ (FET) III-N incluant un drain, une source et une grille ;
Un FET du groupe IV de haute intensité raccordé en série à ce FET III-N ;
Ledit FET du groupe IV de haute intensité limitant un courant au travers dudit FET III-N ;
Un autre FET du groupe IV raccordé entre ladite grille dudit FET III-N et ladite source dudit FET III-N ;
Un autre transistor raccordé entre ladite grille dudit FET III-N et une source dudit FET du groupe IV de haute intensité.

11. Le circuit de la revendication 10, où ledit circuit est un circuit à trois phases.

12. Le circuit de la revendication 10, où ledit circuit est un circuit en pont complet.

13. Le circuit de la revendication 10, où ledit circuit est un circuit en demi-pont.

14. Le circuit de la revendication 10, où ledit circuit est un convertisseur à moteur.

15. Le circuit de la revendication 10, où ledit circuit est configuré pour entraîner une charge inductive.
